# EUROPEAN PATENT APPLICATION

(11) **EP 4 404 387 A1**
(43) Date of publication of application: **24.07.2024**
(21) Application number: 22868599.6
(22) Date of filing: 14.03.2022
(51) Int. Cl.: H01R 11/01

(54) **CABLE CONNECTING STRUCTURE, CABLE CONNECTING ASSEMBLY, AND ELECTRICAL INTERCONNECTION SYSTEM**

(30) Priority: 15.09.2021 CN 202111082963
(71) Applicant: ZTE Corporation, Shenzhen, Guangdong 518057 (CN)
(72) Inventor: ZHANG, Xindan, Shenzhen, Guangdong 518057 (CN); WEI, Zhongmin, Shenzhen, Guangdong 518057 (CN); YI, Bi, Shenzhen, Guangdong 518057 (CN); REN, Yonghui, Shenzhen, Guangdong 518057 (CN); BI, Yu, Shenzhen, Guangdong 518057 (CN)
(74) Representative: Mozzi, Matteo
(86) International application number: PCT/CN2022/080795
(87) International publication number: WO 2023/040219

(57) **Abstract**

Embodiments of the present invention relate to the technical field of signal transmission, and disclose a cable connection structure, a cable connection component, and an electrical interconnection system. The cable connection structure provided by the embodiments of the present invention includes a conductive part and a fixing part for fixing the conductive part. The conductive part includes at least one pair of first signal conductors arranged at an interval in a first direction, and at least one pair of second signal conductors arranged at an interval in a second direction. The first signal conductor is electrically connected to a first-type cable. The second signal conductor is electrically connected to a second-type cable with a diameter greater than that of the first-type cable. The first signal conductors are electrically connected to the second signal conductors in one-to-one correspondence. A width of the first signal conductor in the first direction is less than a width of the second signal conductor in the second direction. The cable connection structure, the cable connection component, and the electrical interconnection system provided by the embodiments of the present invention can reduce a link loss of a system and improve the signal integrity of the system.

## Description

### Cross-Reference to Related Application

This invention claims priority to Chinese Patent Application No. 202111082963.7 filed on September 15, 2021 and entitled "Cable Connection Structure, Cable Connection Component, and Electrical Interconnection System", the invention of which is hereby incorporated by reference in its entirety.

### Technical Field

Embodiments of the present invention relates to the technical field of signal transmission, and in particular, to a cable connection structure, a cable connection component, and an electrical interconnection system.

### Background

With the increasing demand for ultra-high-speed large-capacity transmission devices, signal rates of high-speed products increase continuously. The increase of the signal rates brings great challenges to designs of high-speed links. An insertion loss is the most important parameter in a high-speed interconnection link, which directly affects the feasibility of the high-speed links. As the rate increases, a high-speed cable starts to gradually replace a Printed Circuit Board (PCB) as a key medium of interconnection. A main reason is that a unit length loss of the high-speed cable is lower than that of the PCB. Moreover, the higher the frequency of high-speed cable transmission signals, the lower the loss of the cable compared with that of PCB wiring.

In order to adapt to continuous increasing demand of the signal rates, it is necessary to further reduce a link loss of a system to improve the signal integrity of the system.

### Summary

An objective of embodiments of the present invention is to provide a cable connection structure, a cable connection component, and an electrical interconnection system, which can reduce a link loss of a system and improve the signal integrity of the system.

In order to solve the above technical problems, implementations of the present invention provides a cable connection structure, including a conductive part, and a fixing part for fixing the conductive part. The conductive part includes at least one pair of first signal conductors arranged at an interval in a first direction, and at least one pair of second signal conductors arranged at an interval in a second direction. The first signal conductor is electrically connected to a first-type cable. The second signal conductor is electrically connected to a second-type cable with a diameter greater than that of the first-type cable. The first signal conductors are electrically connected to the second signal conductors in one-to-one correspondence. A width of the first signal conductor in the first direction is less than a width of the second signal conductor in the second direction.

According to the embodiments of the present invention, compared with a related technology, the width of the first signal conductor is less than that of the second signal conductor, so that the first signal conductor and the second signal conductor can be connected to cables with different diameters, a small-sized cable is used close to a chip end, and a large-sized cable is used on one side close to a backplane, thereby avoiding a problem that only the small-sized cable can be used to cause a large link loss due to limitations of space and structure when the cable is directly or indirectly connected to the chip, reducing the link loss of the system, and improving the signal integrity of the system.

### Brief Description of the Drawings

One or more embodiments are exemplarily explained by the pictures in the corresponding accompanying drawings, and the exemplary descriptions do not constitute a limitation to the embodiments. Elements in the drawings having the same reference numerals are denoted by like elements, and unless otherwise stated, the figures in the drawings do not constitute a proportional limitation.
Fig. 1 is a schematic structural diagram of a cable connection structure provided by some embodiments of the present invention.
Fig. 2 is a schematic structural diagram of an electrical connection of the cable connection structure in Fig. 1 and a first-type cable and a second-type cable.
Fig. 3 is a schematic structural diagram of another cable connection structure provided by some embodiments of the present invention.
Fig. 4 is a schematic structural diagram of still another cable connection structure provided by some embodiments of the present invention.
Fig. 5 is a schematic structural diagram of Fig. 4 from another perspective.
Fig. 6 is a schematic structural diagram of an electrical connection of the cable connection structure in Fig. 4 and a first-type cable and a second-type cable.
Fig. 7 is a schematic structural diagram of a yet another cable connection structure provided by some embodiments of the present invention.
Fig. 8 is a schematic structural diagram of Fig. 7 from another perspective.
Fig. 9 is a schematic structural diagram of an electrical connection of a cable connection component provided by some another embodiments of the present invention and a first-type cable and a second-type cable.
Fig. 10 is a front view of an electrical connection of the cable connection component in Fig. 9 and a first-type cable and a second-type cable.
Fig. 11 is a back view of an electrical connection of the cable connection component in Fig. 9 and a first-type cable and a second-type cable.
Fig. 12 is a schematic structural diagram of another cable connection component provided by some another embodiments of the present invention and a first-type -cable and a second-type cable.
Fig. 13 shows a simulation result of an insertion loss of a 20 inch 34AWG cable.
Fig. 14 shows simulation results of insertion losses of the cable connection component in Fig. 9 connected to a 1-inch 34AWG cable and a 19-inch 26AWG cable.
Fig. 15 is a schematic structural diagram of an electrical interconnection system provided by still another some embodiments of the present invention.
Fig. 16 is another schematic structural diagram of an electrical interconnection system provided by still another some embodiments of the present invention.
Fig. 17 is another schematic structural diagram of an electrical interconnection system provided by still another some embodiments of the present invention.
Fig. 18 is a still yet another schematic structural diagram of an electrical interconnection system provided by still another some embodiments of the present invention.
Fig. 19 is a still yet another schematic structural diagram of an electrical interconnection system provided by still another some embodiments of the present invention.
Fig. 20 is a still yet another schematic structural diagram of an electrical interconnection system provided by still another some embodiments of the present invention.

### Detailed Description of the Embodiments

To make the objectives, technical solutions, and advantages of embodiments of the present invention more clearly, various implementations of the present invention will be described in detail with reference to drawings. However, those of ordinary skill in the art can understand that many technical details are proposed in various implementations of the present invention in order to make a reader better understand the present invention. However, the technical solutions claimed in the present invention can also be realized on the basis of various changes and modifications of the following implementations even without these technical details.

The inventor found that a unit length loss of a high-speed cable is closely related to a size of the cable. The larger the size of the cable, the smaller the loss, and the better the high-speed transmission performance. In a related technology, in order to reduce a length of PCB wiring to the greatest extent, there is an increasing trend to place a cable close to a chip or directly integrate the cable to a chip package, which puts strict requirements on the size of cable. Due to limitations of position space and structure of a chip, a cable with a low loss and a large size cannot be used, so that a bandwidth of a high-speed interconnection link is limited to a certain extent, and the link loss is still large.

In order to solve the above technical problems, some embodiments of the present invention relate to a cable connection structure. A core of the present embodiment is that the cable connection structure includes a conductive part 11 and a fixing part 12 for fixing the conductive part 11. The conductive part 11 includes at least one pair of first signal conductors 111 arranged at an interval in a first direction X, and at least one pair of second signal conductors 112 arranged at an interval in a second direction. The first signal conductor 111 is electrically connected to a first-type cable 13. The second signal conductor 112 is electrically connected to a second-type cable 14. A diameter of the second-type cable 14 is greater than that of the first-type cable 13. The first signal conductors 111 are electrically connected to the second signal conductors 112 in one-to-one correspondence. The first signal conductor 111 has a first width in the first direction X, the second signal conductor 112 has a second width in the second direction, and the first width is less than the second width.

The width of the first signal conductor 111 is less than that of the second signal conductor 112, so that the first signal conductor 111 and the second signal conductor 112 can be connected to cables with different diameters, a small-sized cable is used close to a chip end, and a large-sized cable is used on one side close to a backplane, thereby avoiding a problem that only the small-sized cable can be used to cause a large link loss due to limitations of space and structure when the cable is connected to the chip, reducing the link loss of the system, and improving the signal integrity of the system.

Implementation details of the cable connection structure of the present embodiment are described in detail below. The following content is only provided for facilitating understanding the implementation details and is not necessary for implementing the solution.

Specifically, there is a first spacing between each pair of first signal conductors 111 in the first direction X; there is a second spacing between each pair of second signal conductors 112 in the second direction; and the first spacing is smaller than the second spacing. The first width and the first spacing depend on the target design impedance of the two first-type cables 13 (differential signal lines) that are matched and connected and a spacing between the two first-type cables 13 (differential signal lines), and the second width and the second spacing depend on the target design impedance of the two second-type cables 14 (differential signal lines) that are matched and connected and a spacing between the two second-type cables 14 (differential signal lines).

In some embodiments, the first signal conductors 111 and the second signal conductors 112 may be electrically connected in one-to-one correspondence through a pair of first transition signal conductors 113. The second direction may be the same as the first direction X. At this moment, in a direction of the first signal conductor 111 pointing to the second signal conductor 112, a width (a size in the first direction X) of the first transition signal conductor 113 gradually increases. Of course, the second direction and the first direction X may also be different, for example, arranged perpendicular to each other, which is not limited herein.

In order to facilitate understanding, the following describes by taking four arrangement manners of the cable connection structure as examples.

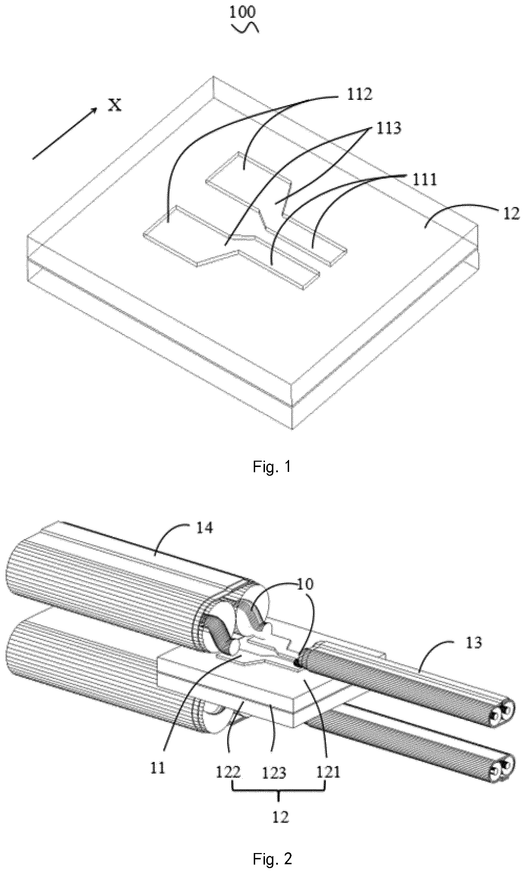

Manner 1: Refer to Fig. 1 and Fig. 2, Fig. 1 is a schematic structural diagram of a cable connection structure 100 provided by an implementation, and Fig. 2 is a schematic structural diagram of an electrical connection between the cable connection structure 100 in Fig. 1 and a first-type cable 13 and a second-type cable 14.

Specifically, the fixing part 12 may include a first dielectric layer 121. The first dielectric layer 121 includes an upper surface and a lower surface that are arranged oppositely. Both the first signal conductors 111 and the second signal conductors 112 are positioned on the upper surface. The first signal conductor 111 includes a first contact surface that is far away from one side of the upper surface and is arranged to electrically connect the first-type cable 13; and the second signal conductor 112 includes a second contact surface that is far away from one side of the upper surface and is arranged to electrically connect the second-type cable 14.

The first-type cable 13 and the second-type cable 14 have similar structures, both including a conductive core 10, and an insulating buffer layer, a shielding layer (may be a metal material), and an insulating protective layer that coat the conductive core in sequence. The conductive core extends (extending out of a cross section of the insulating buffer layer) is bent and welded to the first contact surface and/or the second contact surface.

Optionally, the cable connection structure 100 may further include: at least one pair of third signal conductors (not shown in the drawings) arranged at an interval in the first direction X, and at least one pair of fourth signal conductors (not shown in the drawings) arranged at an interval in the second direction. An arrangement manner of the third signal conductors and the fourth signal conductors is similar to that of the first signal conductors 111 and the second signal conductors 112. Specifically, the third signal conductors are electrically connected to the fourth signal conductors in one-to-one correspondence. The third signal conductor has a third width in the first direction X. The fourth signal conductor has a fourth width in the second direction. The third width is less than the fourth width. The third signal conductors and the fourth signal conductors are all positioned on one side of the lower surface. The third signal conductor includes a third contact surface that is far away from one side of the lower surface and is arranged to electrically connect the first-type cable 13. The fourth signal conductor includes a fourth contact surface that is far away from one side of the lower surface and is arranged to electrically connect the second-type cable 14.

In some embodiments, there is a third spacing between each pair of third signal conductors in the first direction X; there is a fourth spacing between each pair of fourth signal conductors in the second direction; and the third spacing is smaller than the fourth spacing.

In an actual application, the fixing part 12 may further include a second dielectric layer 122, and a ground layer 123 positioned between the first dielectric layer 121 and the second dielectric layer 122. The cable connection structure 100 is grounded through the ground layer 123. The third signal conductors and the fourth signal conductors are positioned on one surface, far away from one side of the first dielectric layer 121, of the second dielectric layer 122. Both the first dielectric layer 121 and the second dielectric layer 122 may be multilayer dielectric layer. Each dielectric layer (PCB) is made of a dielectric material. A dielectric parameter of the dielectric material directly affects the impedance of the conductive part 11.

Optionally, the third signal conductors and the fourth signal conductors may be mirrored symmetrically with the first signal conductors 111 and the second signal conductors 112, respectively about the ground layer 123 (at this moment, the third width is equal to the first width, the second width is equal to the fourth width, the third spacing is equal to the first spacing, and the second spacing is equal to the fourth spacing).

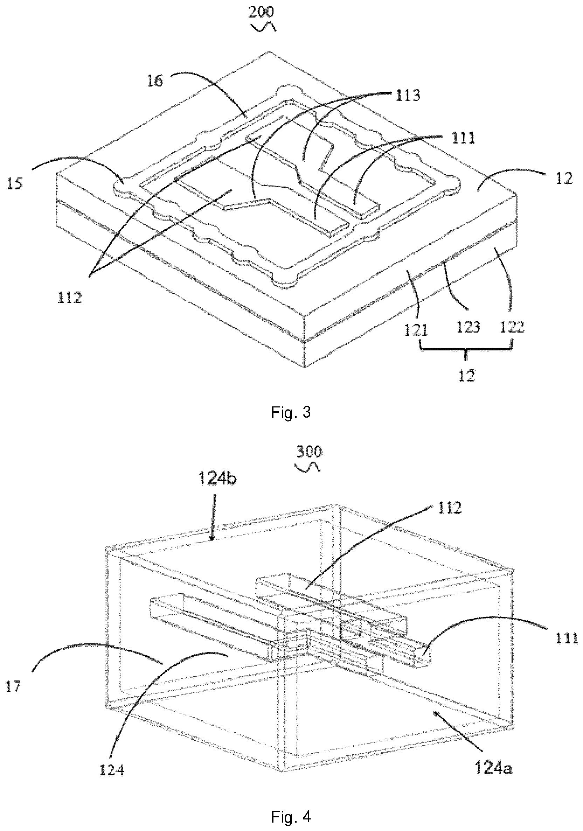

Manner 2: Refer to Fig. 3, Fig. 3 is a schematic structural diagram of another cable connection structure 200 provided by an implementation. Manner 2 is a further improvement based on Manner 1, which may include all or part structural features of Manner 1, and will not be elaborated herein.

Specifically, the fixing part 12 may further include a ground layer 123 positioned on the lower surface. A plurality of conductive through holes 15 surrounding first signal conductors 111 and second signal conductors 112 are arranged on a first dielectric layer 121; and the conductive through holes 15 are electrically connected to the ground layer 123. Crosstalk can be shielded and a backflow path can be provided through such arrangement, so as to reduce an impedance fluctuation of the cable connection structure 200, thereby realizing a lower insertion loss.

In order to realize common ground of the cable connection structure 200 and a cable to achieve a better shielding effect, the conductive through holes 15 may penetrate through the first dielectric layer 121; a ground trace 16 connected to the conductive through holes 15 may also be arranged on the upper surface; and the ground trace 16 is arranged to electrically connect a shielding layer of a first-type cable 13 and/or a second-type cable 14.

Optionally, the ground trace 16 may be connected to a plurality of conductive through holes 15 to form shielding around a conductive part 11. An effect of shielding crosstalk can be further improved through such arrangement.

In some embodiments, the fixing part 12 may further include a second dielectric layer 122 positioned on one side, far away from the first dielectric layer 121, of the ground layer 123. Third signal conductors and fourth signal conductors are arranged on a surface of one side, far away from the ground layer 123, of the second dielectric layer 122 (a specific arrangement manner of the third signal conductors and the fourth signal conductors may be similar to that in Manner 1). A plurality of conductive through holes (the conductive through holes may penetrate through the second dielectric layer 122) that surround the third signal conductors and the fourth signal conductors and are electrically connected to the ground layer 123, and a ground trace connected to the conductive through holes may also be arranged on the second dielectric layer 122.

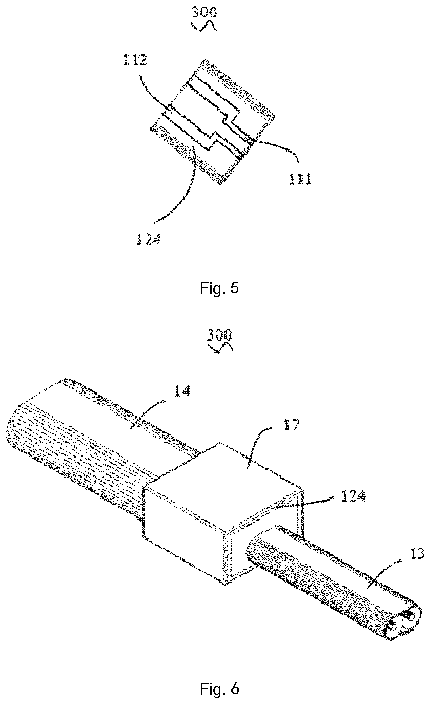

Manner 3: Refer to Fig. 4, Fig. 5, and Fig. 6, Fig. 4 is a schematic structural diagram of another cable connection structure 300 provided by an implementation, Fig. 5 is a schematic structural diagram of Fig. 4 from another perspective, and Fig. 6 is a schematic structural diagram of the cable connection structure 300 in Fig. 4 and a first-type cable 13 and a second-type cable 14.

Specifically, the fixing part 12 may include an insulating body 124. The first signal conductor 111 is embedded into the insulating body 124 and exposes a first connecting end far away from the second signal conductor 112. The first connecting end is arranged to electrically connect the first-type cable 13. The second signal conductor 112 is embedded into the insulating body 124 and exposes a second connecting end far away from the first signal conductor 111. The second connecting end is arranged to electrically connect the second-type cable 14. The insulating body 124 may provide functions of fixing and insulating. A dielectric parameter of an insulating material used by the insulating body 124 directly affects the impedance of the first signal conductor 111 and the second signal conductor 112.

In the present embodiment, the insulating body 124 includes a first surface 124a and a second surface 124b that are arranged oppositely. The first signal conductor 111 exposes the first connecting end at a first surface 124a. The second signal conductor 112 exposes the second connecting end at a second surface 124b.

In an actual application, the cable connection structure 300 may further include a shielding layer 17 wrapping the fixing part 12. The shielding layer 17 avoids the first connecting end and the second connecting end. The shielding layer 17 is made of a conductive material. The shielding layer 17 achieves a fully-surrounded shielding effect.

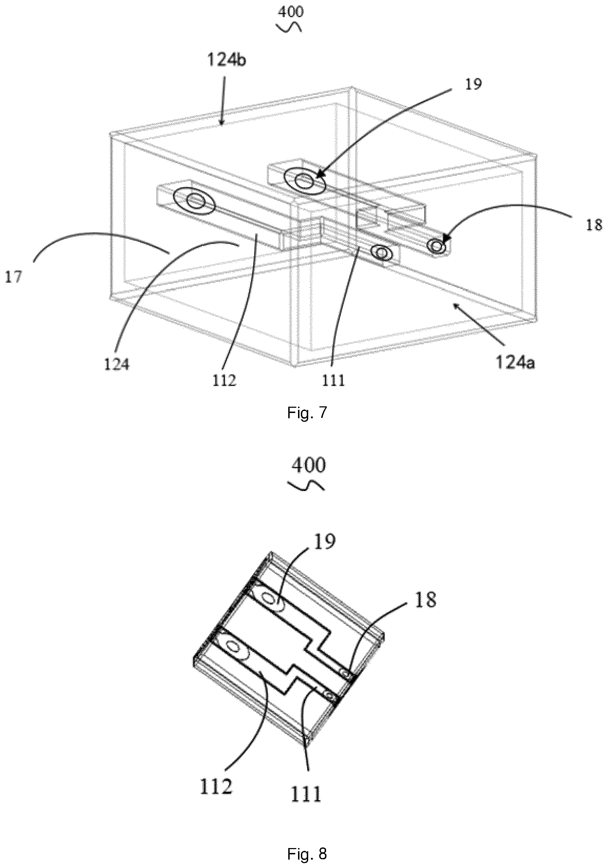

Manner 4: Refer to Fig. 7 and Fig. 8, Fig. 7 is a schematic structural diagram of yet another cable connection structure 400 provided by an implementation, and Fig. 8 is a schematic structural diagram of Fig. 7 from another perspective. Manner 4 is a further improvement based on Manner 3, which may include all or part structural features of Manner 1, and will not be elaborated herein.

Specifically, both the first connecting end and the second connecting end have cylindrical hollow structures. A first elastic structure 18 electrically connected to a first-type cable 13 and a second elastic structure 19 electrically connected to a second-type cable 14 are respectively accommodated in the two hollow structures. An inside diameter of the hollow structure is matched with sizes of the first elastic structure 18 and the second elastic structure 19 (inner walls of the hollow structures are clamped with the first elastic structure and the second elastic structure), so that the first elastic structure 18 and the second elastic structure 19 are in a compressed state after matching, thereby ensuring the reliability of electrical communication between the cable connection structure 400 and a cable.

During actual design of the cable connection structure, the diameters and impedance of the used first-type cable 13 and second-type cable 14 may be determined first, then materials of the dielectric layers (the first dielectric layer 121 and the second dielectric layer 122) and/or the insulating body 124 in the cable connection structure are determined, and finally, the lengths, widths, and spacings of the first signal conductors 111 and the second signal conductors 112 are determined.

According to the embodiments of the present invention, compared with the related technology, the cable connection structure is used to simultaneously matched and connected to two cables in different specifications and a differential signal transmission function, a matching manner includes a PCB or a structural part, which can be more flexibly applied to intra-board and inter-board transmission without limitations of size and space, thereby achieving an effect of reducing a link loss, improving high-speed performance of a passive link of a system, extending application scenarios of a cable system, and improving the signal integrity of the system.

Some other embodiments of the present invention relate to a cable connection component, including a plurality of cable connection structures as described above. The plurality of cable connection structures may be arranged in an array.

In each cable connection component, the first signal conductors of adjacent cable connection structures are positioned on the same side, and the second signal conductors of adjacent cable connection structures are positioned on the other side, so that all first-type cables are positioned on the same side, and all second-type cables are positioned on the other side.

The following describes by taking two examples.

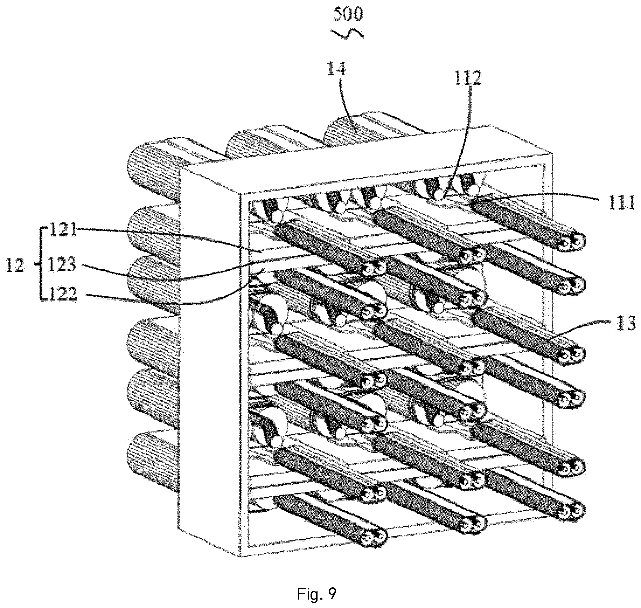

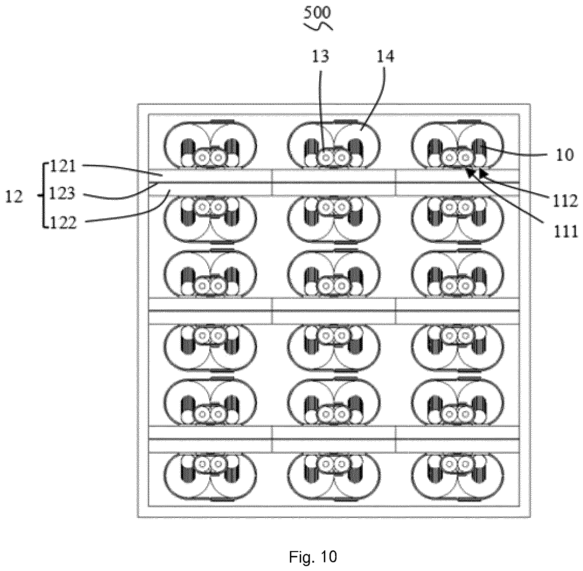

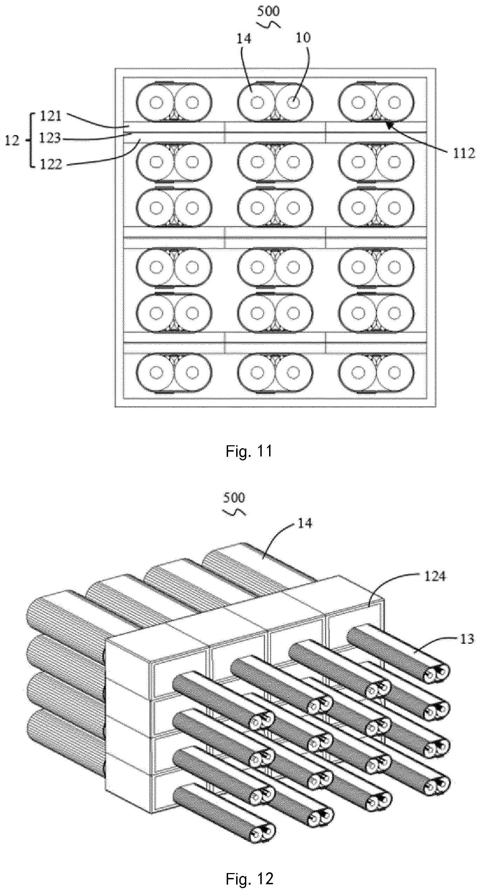

In one example, refer to Fig. 9, Fig. 10, and Fig. 11, Fig. 9 is a schematic structural diagram of an electrical connection of a cable connection component 500 and a first-type cable 13 and a second-type cable 14, Fig. 10 is a front view of an electrical connection of the cable connection component 500 in Fig. 9 and the first-type cable 13 and the second-type cable 14, and Fig. 11 is a back view of an electrical connection of the cable connection component 500 in Fig. 9 and the first-type cable 13 and the second-type cable 14. Each cable connection structure in the cable connection component 500 is similar to the cable connection structure 100 or the cable connection structure 200 in a first implementation. Specifically, first dielectric layers 121, ground layers 123, and second dielectric layers 122 of various cable connection structures in the cable connection component 500 are respectively connected side by side, and a whole body includes a plurality of rows of such structures. First signal conductors 111 and second signal conductors 112 are arranged on a surface of the first dielectric layer 121, and third signal conductors and fourth signal conductors are arranged on a surface of the second dielectric layer 122.

In the other example, refer to Fig. 12, Fig. 12 is a schematic structural diagram of an electrical connection of another cable connection component 500 and a first-type cable 13 and a second-type cable 14. Each cable connection structure in the cable connection component 500 is similar to the cable connection structure 300 or the cable connection structure 400 in a first implementation. Specifically, insulating bodies 124 of various cable connection structures in the cable connection component 500 are stacked in an array. A pair of first signal conductors and a pair of second signal conductors are embedded into each insulating body 124.

In order to facilitate an intuitive observation of an effect of the cable connection component provided by the present invention in reducing an insertion loss, simulation comparison is performed by taking a first cable connection component (that is, the cable connection component shown in Fig. 9) as an example.

The following table shows a comparison of insertion losses of unit lengths of cables with different sizes.

**Table1**

| | Freq | 26AWG | 28AWG | 30AWG | 32AWG | 34AWG |
|---|---|---|---|---|---|---|
| IL dB/in (decibel/inch) | 14GHz | 0.112 | 0.120 | 0.145 | 0.187 | 0.223 |
| | 28GHz | 0.157 | 0.187 | 0.225 | 0.275 | 0.336 |

It can be seen that a unit loss of a cable with a minimum size (34AWG) is approximately twice that of the cable with a maximum size (26AWG).

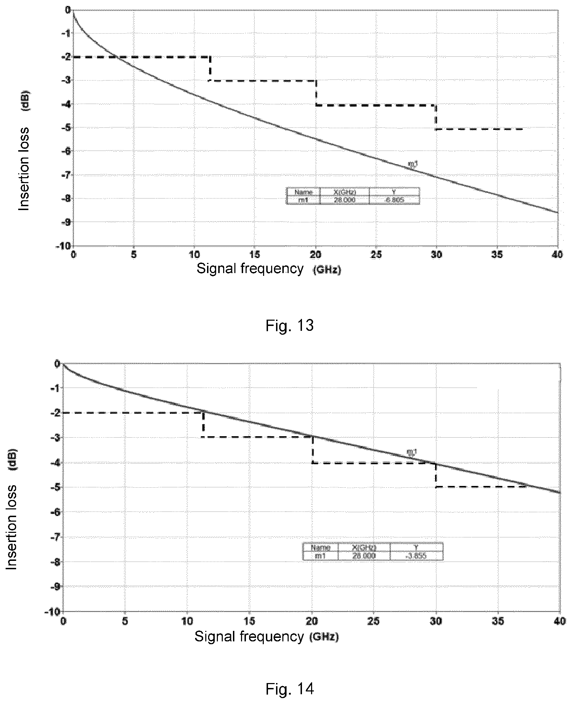

Refer to Fig. 13 and Fig. 14, Fig. 13 shows simulation results of insertion losses of a 20-inch 34AWG cable, and Fig. 14 shows simulation results of insertion losses of the cable connection component in Fig. 9 connected to the 1-inch 34AWG cable and a 19-inch 26AWG cable.

It can be known from Fig. 13 that, the insertion loss of the 20-inch 34AWG cable is 6.805dB (decibel) when a 28GHz differential signal is transmitted. It can be known from Fig. 14 that, the insertion loss of the cable connection component in Fig. 9 connected to the 1-inch 34AWG cable and the 19-inch 26AWG cable is 3.855dB (decibel) when a 28GHz differential signal is transmitted. It can be seen that about 45% of the insertion loss can be reduced by using a solution of the cable connection component in the present invention, which greatly improves the high-speed performance of a passive link of a system.

A first implementation corresponds to the present embodiment, so the embodiment may be implemented in cooperation with the first implementation. Related technical details mentioned in the first implementation are still valid in the present embodiment. The technical effect that can be achieved in the first implementation can also be achieved in the present embodiment, which will not be elaborated herein to reduce repetition. Correspondingly, the related technical details mentioned in the present embodiment may also be applied to the first implementation.

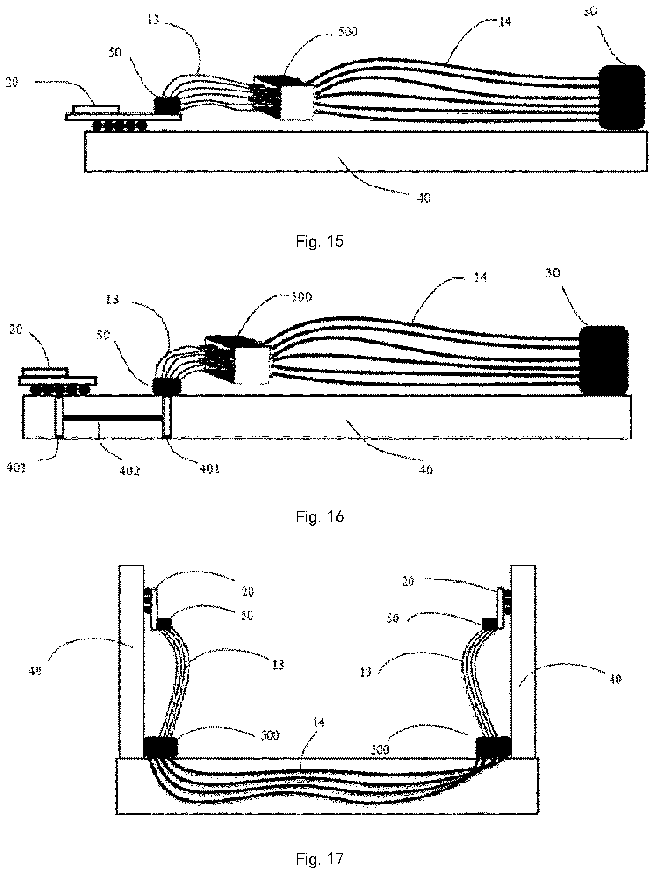

Some other embodiments of the present invention relate to an electrical interconnection system, as shown in Fig. 15, Fig. 16, Fig. 17, Fig. 18, Fig. 19, and Fig. 20, including an Integrated Circuit (IC) chip 20, a first connector 30, and the cable connection component 500 as described above. The IC chip 20 is electrically connected to the first signal conductor in the cable connection component 500 through the first-type cable 13, the first connector 30 is electrically connected to the second signal conductor in the cable connection component 500 through a second-type cable 14, and a diameter of the first-type cable 13 is less than that of the second-type cable 14.

In some embodiments, the electrical interconnection system may further include a circuit board 40 and a second connector 50. Both the IC chip 20 and the second connector 50 are arranged on the circuit board 40, and are electrically connected through internal wiring of the circuit board 40.

It is to be understood that, in some another feasible embodiments, the second connector 50 may also be integrated into a package of the IC chip 20, so there is no need to realize the electrical connection only through the internal wiring of the circuit board 40, thereby avoiding a problem of insertion loss increase caused by the internal wiring of this part.

In an actual application, the electrical interconnection system may be a single board system (an application of the cable connection component 500 in a single board), a backplane architecture system (an application of the cable connection component 500 in backplane architecture), an orthogonal architecture system (an application of the cable connection component 500 in orthogonal architecture), and the like, which are respectively described below by taking examples.

Refer to Fig. 15, Fig. 15 is a schematic structural diagram of the single board system. The cable connection component 500 is positioned on the single board (the circuit board 40). Two ends of the cable connection component 500 are matched and connected to cables (the first-type cable 13 and the second-type cable 14) in two specifications. The first-type cable 13 has a small size specification and is connected to the second connector 50 integrated into the package of the IC chip 20. The second-type cable 14 has a large size specification and is connected to the first connector 30 positioned on a board edge.

The passive link provides a on-board high-speed channel without PCB wiring of all cables for a differential signal. A second connector 50 packaged by an IC chip 20 on a board reaches the board edge of the single board through the first-type cable 13, the cable connection component 500, and the second-type cable 14, and finally through the first connector 30.

Refer to Fig. 16, Fig. 16 is another schematic structural diagram of the single board system. The second connector 50 is positioned close to the IC chip 20. The second connector 50 realizes a connection between the second connector 50 and the IC chip 20 through two conductive through holes 401 in the single board (the circuit board 40) and internal wiring 402 of the PCB. The second connector 50 finally reaches the board edge of the single board through the first-type cable 13, the cable connection component 500, and the second-type cable 14, and finally through the first connector 30.

Refer to Fig. 17, Fig. 17 is a schematic structural diagram of the backplane architecture system. Two cable connection components 500 are respectively positioned at board edges of a switch board and a service board (which are both circuit boards 40). Two ends of the cable connection component 500 are matched and connected to cables (the first-type cable 13 and the second-type cable 14) in two specifications. The first-type cable 13 has a small size specification. Two groups of the first-type cables 13 are respectively connected to the second connectors 50 integrated into the packages of the IC chips 20 in the switch board and the service board (which are both circuit boards 40). The first-type cable 13 is arranged for intra-board signal transmission. The second-type cable 14 has a large size specification. Two ends of the second-type cable 14 are respectively connected to the cable connection components 500 positioned on the board edges of the switch board and the service board. The second-type cable 14 replaces backplane PCB wiring in a traditional backplane.

The passive link provides a high-speed channel without PCB wiring of all cables for a backplane signal. The second connector 50 packaged by the IC chip 20 on the switch board is connected to the cable connection component 500 at the board edge of the switch board through the first-type cable 13, reaches the cable connection component 500 at the board edge of the service board through the second-type cable 14, and finally, reaches the second connector 50 packaged by the IC chip 20 on the service board through the first-type cable 13.

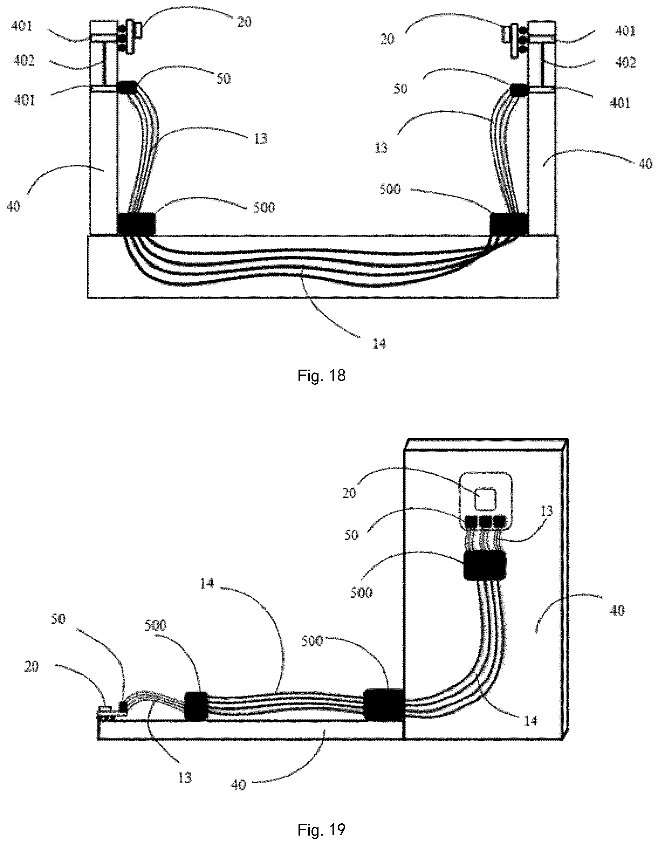

Refer to Fig. 18, Fig. 18 is another schematic structural diagram of the backplane architecture system. The second connector 50 is positioned close to the IC chip 20. The second connector 50 realizes a connection between the second connector 50 and the IC chip 20 through two conductive through holes 401 in the single board (the switch board and/or the service board, which are both circuit boards 40) and internal wiring 402 of the PCB. A connection manner between the two second connectors 50 is similar to that in Fig. 17 (that is, the second connector 50 on the switch board reaches the second connector 50 on the service board through the first-type cable 13, the cable connection component 500 at the board edge of the switch board, the second-type cable 14, the cable connection component 500 at the board edge of the service board, and then the first-type cable 13), which will not be elaborated herein.

Refer to Fig. 19, Fig. 19 is a schematic structural diagram of the orthogonal architecture system. Two cable connection components 500 are respectively positioned in a switch board and a service board (which are both circuit boards 40) and are placed close to chips in the boards. Two ends of the cable connection component 500 are matched and connected to cables (a first-type cable 13 and a second-type cable 14) in two specifications. The first-type cable 13 has a small size specification. Two groups of the first-type cables 13 are respectively connected to the second connectors 50 integrated into the packages of the IC chips 20 in the switch board and the service board. The first-type cable 13 is arranged for intra-board signal transmission. The second-type cable 14 has a large size specification. Two groups of the second-type cables 14 respectively connect the second connectors 50 integrated in the packages of the IC chips 20 in the switch board and the service board to the orthogonal connector on the board edge. The orthogonal connector may be positioned on the switch board or the service board. Both ends of the orthogonal connector are connected to the second-type cables 14.

The passive link provides a high-speed channel without PCB wiring of full-cable for a backplane signal. The second connector 50 packaged by the IC chip 20 on the switch board is connected to the orthogonal connector at a board edge through the first-type cable 13, the cable connection component 500, and the second-type cable 14, and finally, is connected to the second connector 50 packaged by the IC chip 20 on the service board through the second-type cable 14, the cable connection component 500, and the first-type cable 13.

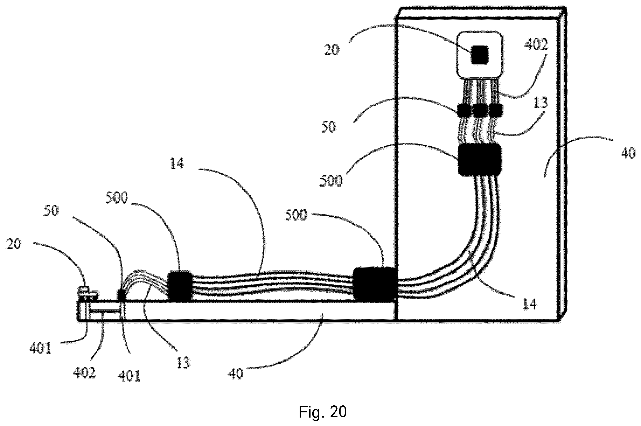

Refer to Fig. 20, Fig. 20 is another schematic structural diagram of the orthogonal architecture system. The second connector 50 is positioned close to the IC chip 20. The second connector 50 realizes a connection between the second connector 50 and the IC chip 20 through two conductive through holes 401 in the single board (the switch board and/or the service board, which are both circuit boards 40) and internal wiring 402 of the PCB. A connection manner between the two second connectors 50 is similar to that in Fig. 19, which will not be elaborated herein.

The present embodiment is a system embodiment corresponding to the aforementioned embodiment, so the present embodiment may be implemented in cooperation with the aforementioned embodiment. Related technical details mentioned in the aforementioned implementation are still valid in the present embodiment. The technical effect that can be achieved in the aforementioned embodiment can also be achieved in the present embodiment, which will not be elaborated herein to reduce repetition. Correspondingly, related technical details mentioned in the present embodiment may also be applied to the aforementioned embodiments.

Those skilled in the art can understand that the above embodiments are specific embodiments to implement the invention. In practical application, various changes can be made in forms and details without departing from the spirit and scope of the invention.

## Claims

1. A cable connection structure, comprising a conductive part, and a fixing part for fixing the conductive part, wherein the conductive part comprises at least one pair of first signal conductors arranged at an interval in a first direction, and at least one pair of second signal conductors arranged at an interval in a second direction; the first signal conductor is electrically connected to a first-type cable; the second signal conductor is electrically connected to a second-type cable with a diameter greater than that of the first-type cable;
the first signal conductors are electrically connected to the second signal conductors in one-to-one correspondence; and a first width of the first signal conductor in the first direction is less than a second width of the second signal conductor in the second direction.

2. The cable connection structure according to claim 1, wherein there is a first spacing between each pair of first signal conductors in the first direction;
there is a second spacing between each pair of second signal conductors in the second direction; and the first spacing is smaller than the second spacing.

3. The cable connection structure according to claim 1, wherein the fixing part comprises a first dielectric layer; the first dielectric layer comprises an upper surface and a lower surface that are arranged oppositely; both the first signal conductors and the second signal conductors are positioned on the upper surface;
the first signal conductor comprises a first contact surface that is far away from one side of the upper surface and is arranged to electrically connect the first-type cable; and the second signal conductor comprises a second contact surface that is far away from one side of the upper surface and is arranged to electrically connect the second-type cable.

4. The cable connection structure according to claim 3, wherein the cable connection structure further comprises at least one pair of third signal conductors arranged at an interval in the first direction, and at least one pair of fourth signal conductors arranged at an interval in the second direction; the third signal conductors are electrically connected to the fourth signal conductors in one-to-one correspondence; a width of the third signal conductor in the first direction is less than a width of the fourth signal conductor in the second direction;
the third signal conductors and the fourth signal conductors are all positioned on one side of the lower surface;
the third signal conductor comprises a third contact surface that is far away from one side of the lower surface and is arranged to electrically connect the first-type cable; and the fourth signal conductor comprises a fourth contact surface that is far away from one side of the lower surface and is arranged to electrically connect the second-type cable.

5. The cable connection structure according to claim 3, wherein the fixing part further comprises a ground layer positioned on the lower surface;
a plurality of conductive through holes surrounding the first signal conductors and the second signal conductors are arranged on the first dielectric layer; and the conductive through holes are electrically connected to the ground layer.

6. The cable connection structure according to claim 5, wherein the conductive through holes penetrate through the first dielectric layer; a ground trace connected to the conductive through holes is also arranged on the upper surface; and the ground trace is arranged to electrically connect a shielding layer of the first-type cable and/or the second-type cable.

7. The cable connection structure according to claim 6, wherein the ground trace is connected to the plurality of conductive through holes to form shielding around the conductive part.

8. The cable connection structure according to claim 1, wherein the fixing part comprises an insulating body; the first signal conductor is embedded into the insulating body and exposes a first connecting end far away from the second signal conductor; the first connecting end is arranged to electrically connect the first-type cable;
the second signal conductor is embedded into the insulating body and exposes a second connecting end far away from the first signal conductor; and the second connecting end is arranged to electrically connect the second-type cable.

9. The cable connection structure according to claim 8, further comprising a shielding layer wrapping the fixing part, wherein the shielding layer avoids the first connecting end and the second connecting end.

10. A cable connection component, comprising a plurality of cable connection structures as claimed in any one of claims to 1 to 9, and the plurality of cable connection structures are arranged in an array.

11. An electrical interconnection system, comprising an Integrated Circuit ,IC, chip, a first connector, and the cable connection structure as claimed in any one of claims 1 to 9, wherein
the IC chip is electrically connected to the first signal conductor through the first-type cable, the first connector is electrically connected to the second signal conductor through a second-type cable, and a diameter of the first-type cable is less than that of the second-type cable.

12. The electrical interconnection system as claimed in claim 1, further comprising a circuit board and a second connector, wherein
both the IC chip and the second connector are arranged on the circuit board, and are electrically connected through internal wiring of the circuit board.
